# EUROPEAN PATENT APPLICATION

(11) **EP 3 915 939 A1**
(43) Date of publication of application: **01.12.2021**
(21) Application number: 20745744.1
(22) Date of filing: 24.01.2020
(51) Int. Cl.: C01F 7/02, C01B 21/072, C08K 3/00, C08L 83/04

(54) **FILLER COMPOSITION, SILICONE RESIN COMPOSITION, AND HEAT DISSIPATION COMPONENT**

(30) Priority: 25.01.2019 JP 2019010735
(71) Applicant: Denka Company Limited, Tokyo 103-8338 (JP)
(72) Inventor: SASAKI, Shuji, Omuta-shi, Fukuoka 836-8510 (JP); NAKAZONO, Junichi, Omuta-shi, Fukuoka 836-8510 (JP); TANOUE, Shotaro, Omuta-shi, Fukuoka 836-8510 (JP)
(74) Representative: Gulde & Partner
(86) International application number: PCT/JP2020/003573
(87) International publication number: WO 2020/153505

(57) **Abstract**

The present invention provides a filler composition excellent in heat dissipation, a silicone resin composition comprising the filler composition and a heat dissipation element made by molding the silicone resin composition. More specifically, the filler composition according to the present invention comprising a filler (A1) having an average particle diameter of 0.3-1.0 µm, a filler (A2) having an average particle diameter of 3-15 µm, and a filler (A3) having an average particle diameter of 35-140 µm, wherein the filler (A1), the filler (A2) and the filler (A3) are one or more kinds selected from alumina, magnesia, AlN covered alumina, AlN and SN.

## Description

### [Technical Field]

The present invention relates to a filler composition, a silicone resin composition and a heat dissipation element.

### [Background Art]

Recent years, electrical equipment is becoming miniaturized and higher performance. With miniaturization and high performance, a mounting density of electronic components is getting higher and, therefore, the need is increasing to effectively dissipate heat generated from electronic components.

In applications for power devices such as electric vehicles that can reduce environmental load, high voltage may be applied to electronic components or large current may flow. In such a case, a high amount of heat is generated. Therefore, in order to deal with the high amount of heat, a demand becomes higher to release heat more effectively than before.

As a technique to meet the demand, for example, Patent document 1 discloses a thermally conductive resin composition composed of three types of fillers.

### [Related Document]

### [Patent Document]

[Patent Document 1] JP2009-164093 A1

### [Disclosure of the Invention]

### [Problem to be solved by the Invention]

A demand for heat dissipation to electronic components and the like is further heightened and more excellent materials in heat dissipation are required.

### [Means for solving the problem]

The present inventors have intensively studied to solve the above problem. As a result, a fact that three types of fillers having different particle sizes, which are excellent in heat dissipation, may be used to further enhance heat dissipation, has been found. More specifically, the present invention proves as follows:

[1] A filler composition comprising a filler (A1) having an average particle diameter of 0.3-1.0 µm, a filler (A2) having an average particle diameter of 3-15 µm, and a filler (A3) having an average particle diameter of 35-140 µm, wherein the filler (A1), the filler (A2) and the filler (A3) are one or more kinds selected from alumina, magnesia, AlN covered alumina, AlN and SN;
[2] The filler composition according to [1], wherein at least one from the filler (A1), the filler (A2) and the filler (A3) is AlN covered alumina;
[3] The filler composition according to [2], wherein the AlN cover amount of the AlN covered alumina is 10-40 mass%;
[4] The filler composition according to any one of [1] to [3], wherein at least one from the filler (A1), the filler (A2) and the filler (A3) is magnesia;
[5] A silicone resin composition comprising the filler composition (A) according to any one of [1] to [4], and silicone resin (B);
[6] A heat dissipation element made by molding the silicone resin composition according to [5].

### [Effects of the Invention]

The filler composition and the resin composition comprising the filler composition according to the present invention may be used to obtain a heat dissipation element excellent in heat dissipation.

### [Mode for Carrying Out the Invention]

Embodiments of the present invention are specifically explained below. However, the present invention should not be limited within the following embodiments.

The filler composition according to the present invention comprises a filler (A1) having an average particle diameter of 0.3-1.0 µm, a filler (A2) having an average particle diameter of 3-15 µm, and a filler (A3) having an average particle diameter of 35-140 µm, wherein the filler (A1), the filler (A2) and the filler (A3) are one or more kinds selected from alumina, magnesia, AlN covered alumina, AlN and SN.

The filler composition according to the present invention is characterized in comprising an ultrafine powder filler (A1), a fine powder filler (A2) and a coarse powder filler (A3) having specific average particle diameters, respectively. If any one of the upper limit values and the lower limit values for average particle diameters of the filler (A1), the filler (A2) and the filler (A3) falls into outside the respective ranges, desired effect cannot be obtained. In this effect of the present invention, it is presumed that thermal conductivity is increased due to formation of a heat transfer pass between filler particles by using three types of fillers: the filler (A1), the filler (A2) and the filler (A3) respectively having three ranges of average particle diameters, and therefore, filling the gap of the filler (A3) with the filler (A2), and further filling the gap of the filler (A2) with the filler (A1).

The average particle diameter of the filler (A1) is 0.3 µm or larger. Since the average particle diameter of the filler (A1) is 0.3 µm or larger, it can effectively enter the gap of the filler (A2) to increase a filling rate, and consequently enhance a thermal conductivity. The average particle diameter of the filler (A1) is preferably 0.4 µm or larger, more preferably 0.5 µm or larger. The average particle diameter of the filler (A1) is 1.0 µm or smaller. Since the average particle diameter of the filler (A1) is 1.0 µm or smaller, the number of particles of the filler (A1) dispersing through the filler increases to reduce the distance between the fillers. Consequently, the heat transfer pass efficiency increases to enhance a thermal conductivity. The average particle diameter of the filler (A1) is preferably 0.9 µm or smaller, more preferably 0.8 µm or smaller.

In this text, average particle diameters are values based on mass-based particle size measurement by laser diffracted light scattering method and measured on a "MASTERSIZER 3000 with a wet type dispersion unit: Hydro MV" manufactured by Malvern Panalytical Ltd. In the measurement, water is used as a solvent, and dispersion treatment is performed as a pretreatment for 2 minutes using an "ULTRASONIC DISRUPTER UD-200 (with a trace amount tip TP-040)" manufactured by TOMY SEIKO Co. Ltd. with an output of 200 W. The dispersion treated filler is dropped into a dispersion unit so that the laser scattering intensity becomes 10-15%. Stirring speed of a dispersion unit stirrer is set to 1750 rpm without an ultrasonic mode. Analysis on particle size distribution is performed by dividing the range of particle size of 0.01-3500 µm into 100 fractions. As a refractive value for water, a value of 1.33 is used and as refractive indexes for fillers, respective literature values. In the measured particle size distribution, the average particle diameter is a value for particles at a cumulative mass of 50%.

In addition, as the filler (A1) having the aforementioned average particle diameter, a commercially available product may be used or one prepared by a known method may be used (the same applied to the filler (A2) and the filler (A3)).

It is preferred that the content of the filler (A1) shall be 5 volume% or more in the filler composition from the viewpoint of enhancing the effect of the present invention. The content of the filler (A1) is more preferably 7 volume% or more, further preferably 10 volume% or more. In addition, it is preferred that the upper limit value shall be 20 volume% or less from the viewpoint of enhancing the effect of the present invention. The content of the filler (A1) is more preferably 18 volume% or less, further preferably 15 volume% or less. Since the content of the filler (A1) is within the aforementioned range, high filling of a filler composition become easy.

It is preferred that the shape of the filler (A1) is spherical from the viewpoint of enhancing filling ability. Since the shape is spherical, the frictional resistance with resin can be reduced and high filling becomes possible. As a degree of sphere, it is preferred that the average sphericity is 0.80 or more. The average sphericity of the filler (A1) is more preferably 0.82 or more, further preferably 0.85 or more.

In this text, an average sphericity of the filler (A1) is measured according to the following method. The filler and ethanol are mixed to prepare a slurry containing 1 mass% of the filler, and dispersion treatment is performed for two minutes by using a "SONIFIER 450 (a crush horn 3/4" solid type)" manufactured by Branson Ltd. at an output level 8. The dispersion slurry is dropped with a pipette on a sample stage coated with carbon paste. After leaving it in the air until the filler dropped on the sample stage dries, osmium coating is applied. Images are taken with a scanning electron microscope "JSM-6301F" manufactured by JOL Ltd. at an imaging magnification of 50000 and a resolution of 1280×960 pixels. The images are imported to a personal computer. These images are analyzed using an image analyzer "MacView Ver. 4" manufactured by Mountech Co., Ltd., and particles are recognized using a simple capturing tool so that sphericity is calculated from a projected area (A) and a perimeter (PM) of a particle. Letting an area of a perfect circle corresponding the above perimeter (PM) be (B), sphericity of the particle is indicted as A/B. When a perfect circle (with a radius r) having the same perimeter as the perimeter (PM) of the sample is assumed, since PM = 2πr and B = πr², then, B = π×(PM/2π)², and a sphericity for the respective particles can be indicated as Sphericity = A/B = A×4π/(PM)². Sphericity values of 200 particles having an arbitrary projected area circle equivalent diameter thus obtained of 10 µm or more are calculated and the average value thereof is considered to be an average sphericity.

The average particle diameter of the filler (A2) is 3 µm or larger. Since the average particle diameter of the filler (A2) is 3 µm or larger, it can effectively enter the gap of the filler (A3) to increase a filling rate, and consequently enhance a thermal conductivity. The average particle diameter of the filler (A2) is preferably 4 µm or larger, more preferably 5 µm or larger. The average particle diameter of the filler (A2) is 15 µm or smaller. Since the average particle diameter of the filler (A2) is 15 µm or smaller, it can also effectively enter the gap of the filler (A3) to increase a filling rate, and consequently enhance thermal conductivity. The average particle diameter of the filler (A2) is preferably 12 µm or smaller, more preferably 10 µm or smaller.

It is preferred that a content of the filler (A2) in the filler composition shall be 25 volume% or more from the viewpoint of enhancing the effect of the present invention. The content of the filler (A2) is more preferably 28 volume% or more, further preferably 30 volume% or more. In addition, it is preferred that the upper limit value shall be 50 volume% or less from the viewpoint of enhancing the effect of the present invention. The content of the filler (A2) is more preferably 45 volume% or less, further preferably 40 volume% or less. Since the content of the filler (A2) is within the aforementioned range, high filling of a filler composition become easy.

It is preferred that the shape of the filler (A2) is spherical from the viewpoint of enhancing filling ability. Since the shape is spherical, the frictional resistance with resin can be reduced and high filling becomes possible. As a degree of sphere, it is preferred that the average sphericity is 0.80 or more. The average sphericity of the filler (A2) is more preferably 0.82 or more, further preferably 0.85 or more.

In this text, an average sphericity of the filler (A2) is measured as the same as the above measurement method for the filler (A1), but only an imaging magnification for the scanning electron microscope was changed to 2000.

The average particle diameter of the filler (A3) is 35 µm or larger. The filler (A3) is a particulate component which is a main particle of the filler. Since the average particle diameter of the filler (A3) is 35 µm or large, a heat transfer pass effect due to a contact between particles can be enhanced. Further, a specific area of particles becomes smaller to increase a filling rate, and consequently thermal conductivity may be further increased. The average particle diameter of the filler (A3) is preferably 45 µm or larger, more preferably 60 µm or larger. The average particle diameter of the filler (A3) shall be 140 µm or smaller. Since the average particle diameter of the filler (A3) is 140 µm or smaller, the surface smoothness of the resin composition filled with filler can be maintained. Consequently, an interface resistance may be reduced to increase thermal conductivity. The average particle diameter of the filler (A3) is preferably 130 µm or smaller, more preferably 120 µm or smaller.

It is preferred that the content of the filler (A3) in the filler composition shall be 50 volume% or more from the viewpoint of enhancing the effect of the present invention The content of the filler (A3) is more preferably 53 volume% or more, further preferably 55 volume% or more. It is preferred that the upper limit value shall be 70 volume% or less from the viewpoint from enhancing the effect of the present invention. The content of the filler (A3) is more preferably 65 volume% or less, further preferably 60 volume% or less. Since the content of the filler (A3) is within the aforementioned range, high filling of a filler composition becomes easy.

It is preferred that a shape of the filler (A3) is spherical from the viewpoint of enhancing filling ability. Since the shape is spherical, the frictional resistance with resin can be reduced and high filling becomes possible. As a degree of sphere, it is preferred that the average sphericity is 0.80 or more. The average sphericity of the filler (A3) is more preferably 0.82 or more, further preferably 0.85 or more.

In this text an average sphericity of the filler (A3) is measured as the same as the above measurement method for the filler (A1), but only an imaging magnification for the scanning electron microscope was changed to 200.

The filler composition according to the present invention may comprises other components from the filler (A1), the filler (A2) and the filler (A3) (including the filler (A1), the filler (A2) and the filler (A3) having an average particle diameter outside the aforementioned ranges). Other components from the fillers include yttrium oxide, boron nitride, calcium oxide, iron oxide, boron oxide and the like. These other components may be intentionally added or contained as impurities. However, from the viewpoint of enhancing the effect of the present invention, the total amount of the filler (A1), the filler (A2) and the filler (A3) is preferably 90 volume% or more, more preferably 95 volume% or more, further preferably 97 volume% or more.

Any one or more selected from alumina, magnesia, AlN covered alumina, AlN and SN may be used as the filler (A1), the filler (A2) and the filler (A3) to manufacture a filler composition excellent in heat dissipation. In the present invention, as the filler (A1), the filler (A2) and the filler (A3), alumina, magnesia, or AlN covered alumina is preferably used.

In order to manufacture a filler composition excellent in thermal conductivity, AlN covered alumina is preferably used. In particular, when the AlN cover amount in the AlN covered alumina with respect to 100 mass% of a raw material alumina is 10 mass% or more, since the thickness of the AlN covered layer on the alumina surface may be thickened, the heat transfer passing ability of the particle surface significantly increases to enhance thermal conductivity. Therefore, the lower limit value of the above AlN cover amount is preferably 10 mass% or more, more preferably 12 mass% or more, further preferably 14 mass% or more. In addition, when an AlN cover amount is 40 mass% or less, the surface of the AlN covered alumina may be smoothened, a filling rate may be increased and thermal conductivity may be enhanced. Therefore, the upper limit value is preferably 40 mass% or less, more preferably 37 mass% or less, further preferably 33 mass% or less. In particular, when AlN covered alumina is used as the filler (A3), a thermal conductivity may effectively be increased. It is presumed that this is because the filler (A3) having the largest average particle diameter among the three types from the filler (A1), the filler (A2) and the filler (A3) has a significant impact on thermal conductivity.

The above AlN covered alumina preferably used in the present invention may be manufactured in the following method.

First, spherical alumina particles and carbon are mixed. In a total amount of the spherical alumina particles and carbon 100 mass%, 20-35 mass% of carbon is mixed with 65-80 mass% of the spherical alumina particle. Commercially available spherical alumina particles may be used, and an average particle diameter of spherical alumina to be used may be appropriately determined based on the average particle diameters for the filler (A1), the filler (A2) and the filler (A3) contained in the filler composition. Examples of carbon types include EC black, acetylene black, carbon black, powdered graphite and the like. In order to obtain AlN covered alumina having high sphericity, among the carbon types, it is preferred that a carbon type having an average particle diameter of 30 nm or larger and 60 nm or smaller, a specific area of 20 m²/g or more and 50 m²/g or less, a powder density of 0.10 g/cm³ or higher and 0.20 g/cm³ or lower is used. A carbon type with these characteristics may be used to suppress coalescence between alumina and obtain AlN covered alumina having high sphericity because a reduction reactive atmosphere is formed and carbon have a contribution as a spacer during calcination describe below. Mixing is performed under the conditions where the spherical alumina particle and carbon can be uniformly dispersed. A method of mixing is not particularly limited and both wet mixing and dry mixing may be used.

Next, calcination is performed on 60-68 g of the mixture of the spherical alumina particle and carbon for surface nitriding. The calcination atmosphere is a nitrogen atmosphere and the flow rate of N₂ gas is controlled in a range of 3-6 L/min. The calcination time is 4-12 hours and the calcination temperature is 1500-1700°C. This calcination process makes AlN covered alumina. The calcination conditions for the above surface nitriding is appropriately adjusted based on a desired AlN cover amount. Higher the calcination temperature, longer the calcination time and larger the N₂ gas flow rate, larger the AlN cover amount.

Next, calcination is performed to remove the remaining carbon on the surface of the AlN covered alumina. The calcination atmosphere is an air atmosphere. The calcination temperature is 600-900°C, and the calcination time is 2-6 hours.

In addition, in order to manufacture a filler composition excellent in thermal conductivity, as the filler (A1), the filler (A2) and the filler (A3), magnesia is preferably used. Since magnesia has a high thermal conductivity, a filler composition specially excellent in thermal conductivity may be manufactured. Examples of methods for manufacturing magnesia include a method comprising: calcining magnesium carbonate (also referred to magnesite); a method comprising: adding calcium hydroxide into see water or an aqueous solution of magnesium chloride (bittern or brine) to produce magnesium hydroxide, and filtering and drying it, followed by calcining it. In order to obtain magnesia having high sphericity, examples include a method of melting and spheroidizing the magnesium power obtained as the above method by plasma spraying and the like.

Further, when the filler (A3) is magnesia, thermal conductivity of the filler composition may be more effectively increased than using AlN covered alumina.

The filler composition according to the present invention may be preferably used to fill a resin as a raw material for members requiring thermal conductivity. As a resin, a silicone resin is preferable. Then, the silicone resin composition according to the present invention is explained below.

The silicone resin composition according to the present invention comprises the filler composition (A) and the silicone resin (B) according to the present invention as above. By combining the filler composition (A) and the silicone resin (B) according to the present invention, a filling rate of the filler composition (A) may be increased. Consequently, a silicone resin composition excellent in thermal conductivity may be manufactured.

Silicone resin (B) is not particularly limited. For example, as the silicone resin (B), a silicone resin such as a peroxide curing type, condensation reaction curing type, addition reaction type, ultraviolet curing type ones and the like may be used.

When the content of the silicone resin (B) in the silicone resin composition according to the present invention is 30 volume% or less, the effect of increasing thermal conductivity by the filler composition (A) according to the present invention may be enhanced. Therefore, the content of the silicone resin (B) in the silicone resin composition according to the present invention is preferably 30 volume% or less, more preferably 25 volume% or lower, further preferably 20 volume% or less. On the other hand, when the content of the silicone resin (B) is too small, it becomes difficult to mold the silicone resin composition to manufacture a desired member. Therefore, the content of the silicone resin (B) is preferably 12 volume% or more, more preferably 15 volume% or more, further preferably 17 volume% or more.

The content of the filler composition (A) in the silicone resin composition according to the present invention is preferably 70 volume% or more, more preferably 75 volume% or more, further preferably 78 volume% or more from the viewpoint of increasing thermal conductivity of the silicone resin composition. On the other hand, when the content of the filler composition (A) is too large, it may become difficult to mold the silicone resin composition. Therefore, the content of the filler composition (A) is preferably 88 volume% or less, more preferably 85 volume% or less, further preferably 83 volume% or less. The silicone resin composition according to the present invention is characterized in increasing a filling rate of the filler composition.

The silicone resin composition may comprises other components from the filler composition (A) and the silicone resin (B). However, since such other components may decrease a filling rate of the filler composition and they themselves have low thermal conductivity. Therefore it is preferred that an amount of the above other component is small. More specifically, the filler composition (A) and the silicone resin (B) are comprised in total preferably 90 volume% or more, more preferably 95 volume% or more, further preferably 97 volume% or more.

When the silicone resin composition according to the present invention is used, a resin composition with high thermal conductivity may be obtained. In particular, according to a preferred embodiment of the present invention, it is possible to make the thermal conductivity measured by the method described in Examples in the range of 5.3 W/m•K or higher. It is sufficiently possible to make the upper limit value, for example, around 110 /m•K.

The silicone resin composition according to the present invention has excellent thermal conductivity as above. Therefore, the silicone resin composition according to the present invention may be preferably used in electronic components. Specifically, it may be preferably used as a material for heat dissipation elements such as semiconductor encapsulant, heat dissipation sheet and the like. Additionally, the silicone resin composition according to the present invention is applied to electronic components as semiconductor encapsulant, heat dissipation sheet and the like by using conventionally known methods.

### [Examples]

### 1. Manufacturing silicone resin compositions

Silicone resin compositions of Examples 1-5 and Comparative examples 1-6 were manufactured.

### [Filler]

The following fillers were used. The average particle diameters were measured by the aforementioned method.

Kinds of alumina having the respective average particle diameters as shown in Table 1 were used. As the average particle diameters, values measured by the aforementioned method are adopted.

Sphericity values measured by the aforementioned method are also shown in Table 1. Additionally, for alumina, the refractive index upon measurement of average particle diameters was set to 1.77.

AlN covered alumina (with an average particle diameter of 50 µm) was manufactured by the following method.

A 50 g of alumina "DAW-45" manufactured by Denka Co., Ltd. and a 10 g of carbon "HS-100" manufactured by Denka Co., Ltd. were used and mixed so that the AlN cover amount became 15 mass%. It was calcined under the conditions where in a nitrogen atmosphere at a N₂ flow rate of 3 L/min., a calcination temperature of 1600°C and a calcination time of 12 hours. After that, under the conditions in an air atmosphere at 700°C for 4 hours, calcination was performed in order to remove carbon. The average particle diameter and sphericity of the obtained AlN covered alumina were measured by the aforementioned methods. The average particle diameter was 50 µm. Additionally, for AlN covered alumina, the refractive index upon measurement of the average particle diameter was set to 1.77.

AlN covered alumina (with an average particle diameter of 55 µm) was manufactured by the following method.

A 50 g of alumina "DAW-45" manufactured by Denka Co., Ltd. and a 18 g of carbon "HS-100" manufactured by Denka Co., Ltd. were used and mixed so that the AlN cover amount became 31 mass%. It was calcined under the conditions where in a nitrogen atmosphere at a N₂ flow rate of 6 L/min., a calcination temperature of 1600°C and a calcination time of 24 hours. After that, under the conditions in an air atmosphere at 700°C for 4 hours, calcination was performed in order to remove carbon. The average particle diameter and sphericity of the obtained AlN covered alumina were measured by the aforementioned methods. The average particle diameter was 55 µm.

Kinds of magnesia having the respective average particle diameters and sphericity values shown in Table 1 were used. Additionally, for magnesia, the refractive index upon measurement of the average particle diameter was set to 1.74.

### [Silicone resin]

The following silicone resin was used.

### (Silicone resin B) Silicone resin "SE-1885" manufactured by Toray Dow corning Co., Ltd.

The filler compositions and the silicone resin were mixed at the respective ratios shown in Table 1 to manufacture silicone resin compositions to form 3 mm-thick specimen.

### [Measurement of thermal conductivity]

The thermal conductivities were measured by a steady state method following ASTM D5470. Measurements were conducted on a resin material thermal resistance measuring device "TRM-046RHHT" manufactured by Hitachi Technologies and Services, Ltd. The silicone resin compositions were processed to a sheet with a width of 10 mm × 10 mm and a thickness of 3 mm, and thermal conductivity values in a thickness direction was measured with applying a 2 N load. Measurement results are shown in Table 1.

**[Table 1]**

| | Filler A1 (Ultrafine Powder) | | | | Filler A2 (Fine Powder) | | | | Filler A3 (Coarse Powder) | | | | Filler D | | | Filling rate (vol%) | Thermal Conductivity |
|---|---|---|---|---|---|---|---|---|---|---|---|---|---|---|---|---|---|
| | Kind | Average Particle Size (µm) | Content (vol%) | Sphericity | Kind | Average Particle Size (µm) | Content (vol%) | Sphericity | Kind | Average Particle Size (µm) | Content (vol%) | Sphericity | Kind | Average Particle Size (µm) | Content (vol%) | | |
| Comparative Example 1 | - | - | - | - | - | - | - | | Al₂O₃ | 100 | - | | - | - | - | | 2.4 |
| Example 1 | Al₂O₃ | 0.3 | 15 | 0.95 | Al₂O₃ | 5 | 30 | 0.93 | Al₂O₃ | 50 | 55 | 0.94 | - | - | - | 80 | 5.3 |
| Example 2 | Al₂O₃ | 0.5 | 10 | 0.87 | Al₂O₃ | 5 | 35 | 0.93 | Al Nitride covered Al₂O₃ (Cover Amount: 15 mass%) | 50 | 55 | 0.93 | - | - | - | 80 | 6.9 |
| Example 3 | Al₂O₃ | 0.8 | 15 | 0.88 | Al₂O₃ | 10 | 30 | 0.91 | MgO | 90 | 55 | 0.93 | - | - | - | 83 | 11.0 |
| Comparative Example 2 | - | - | - | | Al₂O₃ | 5 | 40 | 0.93 | Al₂O₃ | 50 | 60 | 0.94 | - | - | - | 75 | 3.6 |
| Example 4 | Al₂O₃ | 1.0 | 12 | 0.85 | Al₂O₃ | 10 | 30 | 0.91 | Al₂O₃ | 120 | 55 | 0.89 | Al₂O₃ | 0.1 | 3 | 80 | 7.3 |
| Comparative Example 3 | Al₂O₃ | 0.2 | 10 | 0.95 | Al₂O₃ | 5 | 35 | 0.93 | Al₂O₃ | 35 | 55 | 0.95 | - | - | - | 70 | 3.7 |
| Comparative Example 4 | Al₂O₃ | 0.3 | 15 | 0.94 | Al₂O₃ | 2 | 30 | 0.93 | Al₂O₃ | 60 | 55 | 0.93 | - | - | - | 75 | 3.9 |
| Comparative Example 5 | Al₂O₃ | 0.3 | 15 | 0.94 | Al₂O₃ | 20 | 30 | 0.90 | Al₂O₃ | 60 | 55 | 0.93 | - | - | - | 75 | 4.2 |
| Comparative Example 6 | Al₂O₃ | 0.3 | 15 | 0.94 | Al₂O₃ | 5 | 30 | 0.93 | Al₂O₃ | 30 | 55 | 0.94 | - | - | - | 80 | 4.0 |
| Example 5 | Al₂O₃ | 0.5 | 15 | 0.87 | Al₂O₃ | 5 | 30 | 0.93 | Al Nitride covered Al₂O₃ (Cover Amount: 31 mass%) | 55 | 55 | 0.91 | - | - | - | 80 | 8.1 |

## Claims

1. A filler composition comprising a filler (A1) having an average particle diameter of 0.3-1.0 µm, a filler (A2) having an average particle diameter of 3-15 µm, and a filler (A3) having an average particle diameter of 35-140 µm, wherein the filler (A1), the filler (A2) and the filler (A3) are one or more kinds selected from alumina, magnesia, AlN covered alumina, AlN and SN.

2. The filler composition according to claim 1, wherein at least one from the filler (A1), the filler (A2) and the filler (A3) is AlN covered alumina.

3. The filler composition according to claim 2, wherein the AlN cover amount of the AlN covered alumina is 10-40 mass%.

4. The filler composition according to any one of claims 1 to 3, wherein at least one from the filler (A1), the filler (A2) and the filler (A3) is magnesia.

5. A silicone resin composition comprising the filler composition (A) according to any one of claims 1 to 4, and silicone resin (B).

6. A heat dissipation element made by molding the silicone resin composition according to claim 5.
